(19) Europäisches Patentamt
European Patent Office
Office européen des brevets

(11) **EP 3 441 801 A1**

(12) **EUROPEAN PATENT APPLICATION**
published in accordance with Art. 153(4) EPC

(43) Date of publication:
**13.02.2019 Bulletin 2019/07**

(51) Int Cl.:
*G02B 5/30* (2006.01)　　*G02B 5/08* (2006.01)
*G02B 5/26* (2006.01)　　*G02F 1/1333* (2006.01)
*G02F 1/1335* (2006.01)

(21) Application number: **17778960.9**

(22) Date of filing: **22.03.2017**

(86) International application number:
**PCT/JP2017/011349**

(87) International publication number:
**WO 2017/175581 (12.10.2017 Gazette 2017/41)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **07.04.2016　JP 2016077441**

(71) Applicant: **Nippon Kayaku Kabushiki Kaisha Tokyo 100-0005 (JP)**

(72) Inventors:
• **TANAKA Kouichi**
**Tokyo 115-8588 (JP)**
• **HAYASAKI Tomoyuki**
**Tokyo 115-8588 (JP)**

(74) Representative: **Hentrich Patentanwälte PartG mbB**
**Syrlinstraße 35**
**89073 Ulm (DE)**

(54) **LIGHT REFLECTING FILM, AND LIGHT CONTROL FILM AND MIRROR DISPLAY USING SAME**

(57)　The present invention relates to a light reflection film that reduces change of reflection color and transmission color depending on view angles and provides excellent visibility, and a light control film and a mirror display including the light reflection film.

The light reflection film is characterized by including: a visible light reflection unit including at least one visible light reflection layer having a reflection band in which a visible light average reflectance is higher than 25% and equal to or lower than 55% in part or all of a visible light range equal to or longer than 400 nm and shorter than 700 nm; and a light reflection layer PRL-1 having a central reflected wavelength of 700 nm to 950 nm inclusive and having a reflectance higher than 25% and equal to or lower than 55% to ordinary light at the central reflected wavelength, in which the visible light reflection layer and the light reflection layer PRL-1 both reflect polarized light in an identical direction.

FIG. 2

## Description

Technical Field

The present invention relates to a light reflection film suitable for application to, for example, a mirror display, and a light control film using the light reflection film.

Background Art

A mirror display is an image display apparatus including a semi-reflective mirror on the front surface of a display body such as a liquid crystal display (hereinafter referred to as LCD) or an organic EL display (hereinafter referred to as OLED). The mirror display functions as a mirror when displaying no image, and also functions as a display by displaying images.

The mirror display has two functions: that of a mirror and that of a display. However, when a typical semi-reflective mirror is used, a trade-off relation exists between the reflectance of the mirror and the transmissivity of the display body: when one of them is increased, the other is decreased.

To solve this problem, Patent Literatures 1 and 2 disclose technologies in which the display emits polarized light and a polarization mirror or a reflection polarizer is used by a semi-reflective mirror, thereby reducing a loss of light from the display to obtain a bright image.

Examples of the reflection polarizer include, for linearly polarized light a birefringent interference polarizer including a polymer multi-layered film made of two or more kinds of polymers having different refractive indexes, a polarizer called wire grid type and having a fine concavo-convex structure, and also include, for circularly polarized light, a polarizer made of a cholesteric liquid crystal layer. The transmissivity of a display image can be further improved by combining these reflection polarizers with a half wave plate or a quarter wave plate, depending on the state of polarized light emitted from the display. In this case, the mirror display can theoretically have a reflectance of 50% at maximum when used as a mirror, and the transmissivity of light from an image when the mirror display is used as a display can be theoretically 100% at maximum.

Document List

Patent Literatures

Patent Literature 1: Japanese Unexamined Patent Application Publication No. 2005-521086

Patent Literature 2: Japanese Unexamined Patent Application Publication No. 2007-511792

Summary of Invention

Technical Problem

Reflected light and transmitted light from a semi-reflective mirror preferably have achromatic colors, and a mirror is desirably not colored so that the visibility of an image on the mirror and a display image is not decreased. When a cholesteric liquid crystal layer is used as a reflection polarizer, selective reflection of the cholesteric liquid crystal is limited to a particular wavelength band. Thus, in order to reflect visible light and have reflected light in an achromatic color, the reflection polarizer needs to be designed by using a light reflection layer made of cholesteric liquid crystal layers that selectively reflect light in blue, green, and red wavelength regions so that uniform reflection is achieved in a visible light range.

In addition, view angle dependency needs to be considered when the cholesteric liquid crystal layer is used. When cholesteric liquid crystal layers so as to enable uniform reflection in the visible light range are laminated, the semi-reflective mirror has a reflection color in an achromatic color such as silver in the front direction, and thus has a characteristic similarly to that of a normal mirror. However, when the semi-reflective mirror is viewed in an oblique direction, a selective reflection wavelength region of the light reflection layer shifts toward the short wavelength side, and as a result, in the oblique direction, the reflection color is colored in green, and the transmission color is colored in red. Accordingly, desired colors cannot be obtained in a reflection image as a mirror and a display image as a display at a mirror display, which leads to reduced visibility of the mirror display.

It is an object of the present invention to provide a light reflection film that reduces change of reflection color and transmission color depending on view angles and provides excellent visibility when reflective polarizer having angle dependency like cholesteric liquid crystal is used, and a light control film and a mirror display including the light reflection film.

Solution to Problem

In order to solve the above-described problem, the inventors carried out assiduous studies and have newly found that a mirror display which reduces change of reflection color and transmission color at different view angles and provides excellent visibility can be obtained by using a light reflection film including: a visible light reflection unit including at least one visible light reflection layer having a reflection band in which a visible light average reflectance is higher than 25% and equal to or lower than 55% in part or all of a visible light range equal to or longer than 400 nm and shorter than 700 nm; and a light reflection layer PRL-1 having a central reflected wavelength of 700 nm to 950 nm inclusive and having a reflectance higher than 25% and equal to or lower than 55% to ordinary light at the central reflected wavelength, where the visible light reflection layer and the light reflection layer PRL-1 both reflect polarized light in an identical direction, and have reached the present invention. Note that PRL is an abbreviation of Polarized light Reflection Layer which is an alphabetical denotation representing a light reflecting layer.

Specifically, the subject matters of the present invention are as follows:

(1) A light reflection film characterized by including a visible light reflection unit including at least one visible light reflection layer having a reflection band in which a visible light average reflectance is higher than 25% and equal to or lower than 55% in part or all of a visible light range equal to or longer than 400 nm and shorter than 700 nm; and a light reflection layer PRL-1 having a central reflected wavelength of 700 nm to 950 nm inclusive and having a reflectance higher than 25% and equal to or lower than 55% to ordinary light at the central reflected wavelength, in which the visible light reflection layer and the light reflection layer PRL-1 both reflect polarized light in an identical direction.

(2) The light reflection film according to (1), characterized in that the visible light reflection unit includes at least one visible light reflection layer among: a visible light reflection layer PRL-2 having a central reflected wavelength equal to or longer than 400 nm and shorter than 500 nm and having a reflectance higher than 25% and equal to or lower than 55% to ordinary light at the central reflected wavelength; a visible light reflection layer PRL-3 having a central reflected wavelength equal to or longer than 500 nm and shorter than 600 nm and having a reflectance higher than 25% and equal to or lower than 55% to ordinary light at the central reflected wavelength; and a visible light reflection layer PRL-4 having a central reflected wavelength equal to or longer than 600 nm and shorter than 700 nm and having a reflectance higher than 25% and equal to or lower than 55% to ordinary light at the central reflected wavelength.

(3) The light reflection film according to (2), characterized in that the visible light reflection unit includes three visible light reflection layers of the visible light reflection layer PRL-2, the visible light reflection layer PRL-3 and the visible light reflection layer PRL-4.

(4) The light reflection film according to any one of (1) to (3), characterized in that the visible light reflection layer and the light reflection layer PRL-1 are each a cholesteric liquid crystal layer having a fixed helical orientation.

(5) A light control film characterized in that the light reflection film according to any one of (1) to (4) and a quarter wave plate are laminated.

(6) A mirror display characterized in that the light reflection film according to any one of (1) to (4) or the light control film according to (5) is arranged on a front surface of an image display apparatus.

(7) The mirror display according to (6), characterized in that the image display apparatus is a liquid crystal display or an organic EL display.

(8) The mirror display according to (7), characterized in that the image display apparatus is a liquid crystal display or an organic EL display including a flexible substrate.

(9) The mirror display according to (8), characterized in that the display entirely has a curved surface shape.

Effects of Invention

A light reflection film according to the present invention can reduce change of reflection color and transmission color depending on view angles, and thus a mirror display providing excellent visibility that can display a reflection image as a mirror and a display image as a display like those in the front direction at any position can be obtained. Moreover, a uniform reflection image or a uniform image can be displayed on the display, if the display is deformable or has a curved surface shape.

Brief Description of Drawings

[Fig. 1] A schematic sectional view illustrating an embodiment of a light reflection layer used in the present invention.
[Fig. 2] A schematic sectional view illustrating an embodiment of a light reflection film according to the present invention.
[Fig. 3] A schematic sectional view illustrating an embodiment of a light control film according to the present invention.
[Fig. 4] A schematic sectional view illustrating an embodiment of a mirror display according to the present invention.

Description of Embodiments

The following describes representative light reflection film, light control film and mirror display according to the present invention. The following embodiments are merely as exampled as representative embodiments for explaining the present invention, and various kinds of additional changes may be performed within the scope of the present invention.
In the present invention, a central reflected wavelength is a wavelength as an average of wavelengths on short and long wavelength sides that correspond to 80% of the maximum reflectance of a single visible light reflection layer or light reflection layer PRL-1. For example, when a single visible light reflection layer has a maximum reflectance of 50% to ordinary light, $\lambda 2$ given by Formula (1) below represents the central reflected wavelength, where $\lambda 1$ and $\lambda 3$ represent wavelengths on the short and long wavelength sides, respectively, at which a reflectance of 40% corresponding to 80% of the maximum reflectance is obtained.

$$(\lambda 1 + \lambda 3) / 2 = \lambda 2 \ldots (1)$$

In the present invention, a visible light average reflectance is an average of the reflectance of each visible light reflection layer to ordinary light at the central reflected wavelength in case of a lamination of a single or plurality of visible light reflection layers. For example, when a light reflection film in the present invention includes three visible light reflection layers, and the reflectance of the visible light reflection layers to ordinary light at the central reflected wavelength is 40%, 38% and 30% respectively, the visible light average reflectance is given by (40 + 38 + 30)/3 = 36%.
Each light reflection layer configuring the light reflection film according to the present invention has high reflectance for particularly polarized external light. Polarized light mainly includes linearly polarized light and circularly polarized light. Examples of light reflection layer that reflects such polarized light include, for linearly polarized light, a birefringent interference reflective polarizer including a polymer multi-layered film made of two or more kinds of polymers having different refractive indexes, and a reflective polarizer called wire grid type and having a fine concavo-convex structure, and also include, for circularly polarized light, a reflective polarizer made of a cholesteric liquid crystal layer. For example, when the mirror display is applied to a smartphone, a display image needs to be visible in both of the portrait direction and the landscape direction. However, when linearly polarized light is reflected, the direction of emitted polarized light differs by 90° between the portrait direction and the landscape direction, and thus the image becomes invisible in some cases depending on the display direction when seen through polarization sunglasses. However, when circularly polarized light is reflected, the state of the circularly polarized light does not change with change of the display direction, and thus the display image is visible at the same brightness irrespective of change of the display direction when seen polarization sunglasses. For this reason, each light reflection layer configuring the light reflection film according to the present invention preferably reflects circularly polarized light.
Each visible light reflection layer used in the present invention reflects light in a visible light range as uniformly as possible, thereby reducing coloring of reflected light and transmitted light in the front direction. Light in the visible light range has a wavelength in a range equal to or longer than 400 nm and shorter than 700 nm. For example, when a reflective polarizer including cholesteric liquid crystal is used, a single visible light reflection layer made of a cholesteric liquid crystal layer desirably uniformly reflects light in the visible light range. However, when the reflection band of the single layer is narrow, a plurality of visible light reflection layers having different reflection bands can be laminated to adjust uniform reflection of light in the visible light range at the visible light reflection layers.

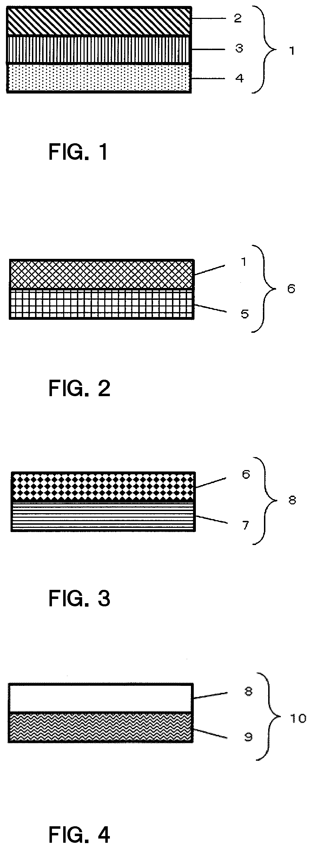

Fig. 1 exemplarily illustrates a configuration diagram of a visible light reflection unit 1 used in the present invention in which a plurality of visible light reflection layers having different reflection bands are laminated. The visible light reflection unit 1 in Fig. 1 includes a lamination of three visible light reflection layers of: PRL-2 as a visible light reflection layer 2 having a central reflected wavelength in a range equal to or longer than 400 nm and shorter than 500 nm, which corresponds to a blue region, and having a reflectance higher than 25% and equal to or lower than 55% to ordinary light at the central reflected wavelength; PRL-3 as a visible light reflection layer 3 having a central reflected wavelength in a range equal to or longer than 500 nm and shorter than 600 nm, which corresponds to a green region, and having a reflectance higher than 25% and equal to or lower than 55% to ordinary light at the central reflected wavelength; and PRL-4 as a visible light reflection layer 4 having a central reflected wavelength in a range equal to or longer than 600 nm and shorter than 700 nm, which corresponds to a red region, and having a reflectance higher than 25% and equal to or lower than 55% to ordinary light at the central reflected wavelength. In this case, the lamination of three visible light reflection layers having selective reflection regions at least in the blue, green, and red regions can reduce coloring of reflected light and transmitted light in the front direction. These visible light reflection layers preferably have substantially equal reflectance to ordinary light at the central reflected wavelengths, and for example, the difference between the reflectance to ordinary light of the visible light reflection layers is preferably 0% to 10%, more preferably 0% to 5%. Accordingly, when a plurality of visible light reflection layers having different reflection bands are laminated, light in the visible light range can be reflected as uniformly as possible at the visible light reflection layers, and as a result, coloring of reflected light and transmitted light in the front direction can be reduced. The reflectance to ordinary light of the visible light reflection layers PRL-2, PRL-3, and PRL-4 are each higher than 25% and equal to or lower than 55%, preferably 30% to 50% inclusive, more preferably 40% to 50% inclusive approximately, so that a light reflection film functions as a mirror and visibility is improved viewpoint at image display on a display.

In each visible light reflection layer used in the present invention, reflected wavelength depends on the angles of incident light in some cases. For example, when the visible light reflection layer is made of a cholesteric liquid crystal layer, the central reflected wavelength $\lambda 2$ shifts toward the short wavelength side as tilt increases with respect to the front direction of the visible light reflection layer. In this case, for example, when the visible light reflection layer includes the visible light reflection layers PRL-2, PRL-3, and PRL-4, even though the central reflected wavelength $\lambda 2$ of each of the visible light reflection layers PRL-2, PRL-3, and PRL-4 shift toward the short wavelength side, another visible light reflection layer having a central reflected wavelength closer to the long wavelength side than the central reflected wavelength of the visible light reflection layer reflects visible light instead, thereby reducing change of the color of reflected light. However, when the angle of incident light is increased, the reflection band of visible light that can be reflected shifts toward the short wavelength side, but visible light in the reflection band of the visible light reflection layer PRL-4 on the long wavelength side cannot be reflected. As a result, reflected light is colored in green to blue colors, and transmitted light is colored in red to yellow colors in some cases. This means that, when such a visible light reflection layer is applied to a mirror display, a reflection image as a mirror is colored in green to blue colors depending on the view angles, a display image as the display is colored in red to yellow colors depending on the view angles, and as a result, the reflection and display images different from an image seen in the front direction are displayed on the mirror display.

The light reflection film according to the present invention further laminates, in addition to the visible light reflection unit, a light reflection layer PRL-1 that has a central reflected wavelength of 700 nm to 950 nm inclusive, has a reflectance higher than 25% and equal to or lower than 55% to ordinary light at the central reflected wavelength, and has characteristic of reflecting polarized light in the same direction as the visible light reflection layer in the visible light reflection unit. The light reflection layer PRL-1 used in the present invention is same as the other visible light reflection layers PRL-2, PRL-3, and PRL-4 except that the light reflection layer PRL-1 has a central reflected wavelength in a near-infrared region. The light reflection layer PRL-1 has no reflection band in the visible light range for the front direction, and thus is transparent. However, when the light reflection layer PRL-1 is tilted, the reflection band shifts toward the short wavelength side, thereby the light reflection layer PRL-1 reflects light in the visible light range. Thus, by setting the center reflection wavelength of the light reflection layer PRL-1 so as to shift to the reflection band of the visible light reflection layer, in particular the reflection band of the visible light reflection layer PRL-4, even when viewed from an oblique direction, it is possible to obtain a light reflecting film in which the reflected light and the transmitted light are the same color as the front direction.. Specifically, the central reflected wavelength of the light reflection layer PRL-1 is preferably 720 nm to 900 nm inclusive, more preferably 730 nm to 900 nm inclusive, further preferably 730 nm to 850 nm inclusive, so as to be more easily shifted to the reflection band of the visible light reflection layer. In order to make the reflected light of the light reflecting layer PRL-1 accompanying the shift of the reflection band toward the shorter wavelength side uniform with the reflected light of the visible light reflection layer in the visible light region, the reflectance to ordinary light of the light reflection layer PRL-1 is desirably adjusted to be substantially equal to the visible light average reflectance of the visible light reflection layer, preferably 30% to 50 % inclusive, more preferably 40% to 50% or inclusive.

Fig. 2 exemplarily illustrates the configuration of a light reflection film 6 according to the present invention including the visible light reflection unit 1 in Fig. 1 and PRL-1 as a light reflection layer 5. The light reflection layer PRL-1 is laminated together with the visible light reflection layers PRL-2, PRL-3, and PRL-4 in Fig. 1. The light reflection layer PRL-1 and the visible light reflection layers PRL-2, PRL-3, and PRL-4 are not limited to a particular lamination order, but may be arranged at optional positions in the thickness direction. The light reflection layer PRL-1 and a single or plurality of visible light reflection layer(s) may be each laminated directly or through a colorless and transparent adhesive layer made of a pressure sensitive adhesive or an adhesive. For example, in the visible light reflection unit 1 including the visible light reflection layers PRL-2, PRL-3, and PRL-4 illustrated in Fig. 1, the visible light reflection layers PRL-2, PRL-3, and PRL-4 may be each laminated with an adhesive layer interposed therebetween, and the visible light reflection unit 1 and the light reflection layer PRL-1 may be laminated with an adhesive layer interposed therebetween in Fig. 2.

As the pressure sensitive adhesive, acrylic or rubber based pressure sensitive adhesive can be mentioned, it is preferable to employ an acrylic pressure sensitive adhesive for which adhesiveness, a holding force etc. is easy to be adjusted. As the adhesive, for example, an ultraviolet curing type resin composition, a heat curing type resin composition and a mixture thereof can be mentioned. In the case of an ultraviolet curing type resin, a composition obtained by mixing a plurality of monomers having an acryloyl group or an epoxy group is irradiated with ultraviolet in the presence of a photopolymerization initiator to thereby adhere.. In the case of a heat curing type resin composition, a composition obtained by mixing a plurality of monomers having an epoxy group is heated in the presence of an acid catalyst to thereby cure and adhere. Alternatively, a composition containing on a plurality of monomers or polymers having an amino group, a carboxyl group or a hydroxyl group may be heated in the presence of a compound having an isocyanate group or melamine to thereby cure and adhered. When the visible light reflection layers and the light reflection layer PRL-1 used in the present invention are laminated with an adhesive layer interposed therebetween, the thickness of the adhesive layer is not particularly limited as long as these light reflection layers can be adhered without adverse influence on reflection and transmission characteristics of the light reflection film, but is, for example, 1 $\mu$m to 20 $\mu$m.

The light reflection layer PRL-1 used in the present invention has a reflection band in the near-infrared region, and thus provides a heat shielding effect against sunlight. Thus, the light reflection film according to the present invention including at least one of the visible light reflection layers PRL-2, PRL-3 and PRL-4, as well as the light reflection layer PRL-1 can improve angle dependencies of a reflection image on a mirror display and a display image on a display and further can contribute to reduction of suppression of an increase in the temperature inside the display by the heat shielding effect. In particular, the heat shielding effect is effective for a mirror display for digital signage used in an outdoor space or a space in which air conditioning is unavailable.

The light reflection film according to the present invention can be configured so as to reflect either right-handed circularly polarized light or left-handed circularly polarized light when visible light reflection layer and the light reflection layer PRL-1 are cholesteric liquid crystal layers respectively. However, as described above, when a plurality of light reflection layers are laminated, laminated visible light reflection layer and the light reflection layer PRL-1 are required to have a characteristic of reflecting circularly polarized light in the same direction.

A cholesteric liquid crystal used for the light reflection layer is composed of a nematic liquid crystal having chirality or a composition obtained by adding a chiral agent to a nematic liquid crystal. It is preferable to obtain a cholesteric liquid crystal by adding a chiral agent to a nematic liquid crystal, since helical orientation of or reflected wavelength can be optionally designed depending on the kind and amount of the chiral agent. Unlike a liquid crystal operated by an electric field, the nematic liquid crystal in the present invention is used while the helical orientation thereof is fixed, and thus it is preferable to use a nematic liquid crystal monomer having a polymerizable group.

The nematic liquid crystal monomer having a polymerizable group is a compound having a polymerizable group in a molecule and having liquid crystallinity in a certain emperature range or concentration range. Examples of the polymerizable group include a (meth)acryloyl group, a vinyl group, a chalconyl group, a cinnamoyl group and an epoxy group. It is preferable that a mesogenic group is contained in a molecule to have liquid crystallinity. The mesogenic group is, for example, a rod-shaped or plate-shaped substituent such as a biphenyl group, a terphenyl group, a (poly)phenyl benzonate group, a (poly)ether group, a benzylideneaniline group and an acenaphthoquinoxaline group; or a disk-shaped substituent such as a triphenylene group, a phthalocyanine group and an azacrown group. Thus, the mesogenic group is a group capable of inducing liquid crystal phase behavior. A liquid crystal compound having a rod-shaped or plate-shaped group is known as a calamitic liquid crystal in this technical field. Examples of nematic liquid crystal monomers having such a polymerizable group include polymerizable liquid crystals disclosed in Japanese Patent Application Laid-Open No. 2003-315556 and Japanese Patent Application Laid-Open No. 2004-29824, PALIOCOLOR series (manufactured by BASF Ltd.) and RMM series (manufactured by Merck KGaA). These nematic liquid crystal monomers having a polymerizable group may be used alone or may be used as a mixture of two or more monomers.

The chiral agent is preferably a compound that is capable of inducing right-handed or left-handed helical orientation of the above-described nematic liquid crystal monomer having a polymerizable group and has a polymerizable group similarly to the nematic liquid crystal monomer having a polymerizable group. Such a chiral agent is, for example, Paliocolor LC756 (manufactured by BASF Ltd.) compounds described in Japanese Patent Application Laid-Open No. 2002-179668. The orientation of circularly polarized light to be reflected is determined by the kind of the chiral agent, and the reflected wavelength of the light reflection layer can be changed in accordance with the amount of the chiral agent added to nematic liquid crystal. For example, a light reflection layer that reflects light having a wavelength on a shorter wavelength side can be obtained by increasing the amount of the added chiral agent. The amount of the added chiral agent differs depending on the kind and reflected wavelength of the chiral agent, but is preferably 0.5 to 30 parts by mass approximately based on 100 parts by mass of the nematic liquid crystal monomer having a polymerizable group, more preferably 1 to 20 parts by mass, further preferably 3 to 10 parts by mass, in order to control the central reflected wavelength $\lambda$2 of a light reflection layer to ordinary light to a desired wavelength region.

In addition, a polymerizable compound having no liquid crystallinity that can react with a nematic liquid crystal monomer having a polymerizable group may be added. Such a compound is, for example, ultraviolet curing type resin.

Examples of the ultraviolet curing type resin include dipentaerythritol hexa(meth)acrylate, a reaction product of dipentaerythritol penta(meth)acrylate and 1,6-hexamethylene diisocyanate, a reaction product of isocyanuric-ring-containing triisocyanate and pentaerythritol tri(meth)acrylate, a reaction product of pentaerythritol tri(meth)acrylate and isophorone diisocyanate, dipentaerythritol penta(meth)acrylate, dipentaerythritol tetra(meth)acrylate, pentaerythritol tetra(meth)acrylate, pentaerythritol tri(meth)acrylate, trimethylolpropane tri(meth)acrylate, ditrimethylolpropane tetra(meth)acrylate, tris (acryloxyethyl)isocyanurate, tris(methacryloxyethyl)isocyanurate, a reaction product of glycerol triglycidyl ether and (meth)acrylic acid, caprolactone denaturated tris(acryloxyethyl)isocyanurate, a reaction product of trimethylolpropane triglycidyl ether and (meth)acrylic acid, triglycerol di(meth)acrylate, a reaction product of propylene glycol diglycidyl ether and (meth)acrylic acid, polypropylene glycol-di-(meth)acrylate, tripropylene glycol-di(meth)acrylate, polyethylene glycol di(meth)acrylate, tetraethylene glycol di(meth)acrylate, triethylene glycol di(meth)acrylate, pentaerythritol di(meth)acrylate, a reaction product of 1,6-hexanediol diglycidyl ether and (meth)acrylic acid, 1,6-hexanediol di(meth)acrylate, glycerol di(meth)acrylate, a reaction product of ethylene glycol diglycidyl ether and (meth)acrylic acid, a reaction product of diethylene glycol diglycidyl ether and (meth)acrylic acid, bis(acryloxyethyl)hydroxyethyl isocyanurate, bis(methacryloxyethyl)hydroxyethyl isocyanurate, a reaction product of bisphenol A diglycidyl ether and (meth)acrylic acid, tetrahydrofurfuryl (meth)acrylate, caprolactone denaturated tetrahydrofurfuryl (meth)acrylate, 2-hydroxyethyl (meth)acrylate, 2-hydroxypropyl (meth)acrylate, polypropylene glycol (meth)acrylate, polyethylene glycol (meth)acrylate, phenoxy hydroxypropyl (meth) acrylate, acryloyl morpholine, methoxy polyethylene glycol (meth)acrylate, methoxy tetraethylene glycol (meth)acrylate, methoxy triethylene glycol (meth)acrylate, methoxy ethylene glycol (meth)acrylate, methoxy ethyl (meth)acrylate, glycidyl (meth)acrylate, glycerol (meth)acrylate, ethyl carbitol (meth)acrylate, 2-ethoxyethyl (meth)acrylate, N,N-dimethylaminoethyl (meth)acrylate, 2-cyanoethyl (meth)acrylate, a reaction product of butyl glycidyl ether and (meth)acrylic acid, butoxy triethylene glycol (meth)acrylate, and butanediol mono(meth)acrylate. These resins may be used alone or may be used as a mixture of some of the resins. These ultraviolet curing type resins having no liquid crystallinity need to be added in such an amount that the nematic liquid crystal monomer having a polymerizable group does not lose liquid crystallinity, and the amount added is preferably 0.1 to 20 parts by mass based on 100 parts by mass of the nematic liquid crystal monomer having a polymerizable group, more preferably 1.0 to 10 parts by mass.

When the nematic liquid crystal monomer having a polymerizable group used in the present invention and the other polymerizable compound are ultraviolet curing type, a photopolymerization initiator is added in order cure the liquid crystal composition containing them by ultraviolet ray. Examples of the photopolymerization initiator include: 2-methyl-1-[4-(methylthio)phenyl]-2-morpholinopropane-1 (Irgacure 907 manufactured by BASF Ltd.), 1-hydroxy cyclohexyl phenyl ketone (Irgacure 184 manufactured by BASF Ltd.), 4-(2-hydroxyethoxy)-phenyl(2-hydroxy-2-propyl) ketone (Irgacure 2959 manufactured by BASF Ltd.), 1-(4-dodecylphenyl)-2-hydroxy-2-methylpropan-1-one (Darocure 953 manufactured by Merck KGaA), 1-(4-isopropylphenyl)-2-hydroxy-2-methylpropan-1-one (Darocure 1116 manufactured by Merck KGaA), 2-hydroxy-2-methyl-1-phenylpropan-1-one (Irgacure 1173 manufactured by BASF Ltd.), an acetophenone compound such as diethoxyacetophenone, benzoin compounds such as benzoin, benzoin methyl ether, benzoin ethyl ether, benzoin isopropyl ether, benzoin isobutyl ether and 2,2-dimethoxy-2-phenylacetophenone (Irgacure 651 manufactured by BASF Ltd.), benzophenone compounds such as benzoylbenzoic acid, methyl benzoylbenzoate, 4-phenylbenzophenone, hydroxybenzophenone, 4-benzoyl-4'-methyldiphenyl sulfide and 3,3'-dimethyl-4-methoxybenzophenone (Kayacure MBP manufactured by Nippon Kayaku Co., Ltd.), and thioxanthone compounds such as thioxanthone, 2-chlorthioxanthone (Kayacure CTX manufactured by Nippon Kayaku Co., Ltd.), 2-methylthioxanthone, 2,4-dimethylthioxanthone (Kayacure RTX manufactured by Nippon Kayaku Co., Ltd.), isopropyl thioxanthone, 2,4-dichlorthioxanthone (Kayacure CTX manufactured by Nippon Kayaku Co., Ltd.), 2,4-diethylthioxanthone (Kayacure DETX manufactured by Nippon Kayaku Co., Ltd.), or 2,4-diisopropylthioxanthone (Kayacure DITX manufactured by Nippon Kayaku Co., Ltd.). The photopolymerization initiator is preferably, for example, Irgacure TPO, Irgacure TPO-L, Irgacure OXE01, Irgacure OXE02, Irgacure 1300, Irgacure 184, Irgacure 369, Irgacure 379, Irgacure 819, Irgacure 127, Irgacure 907, or Irgacure 1173 (all manufactured by BASF Ltd.), more preferably, Irgacure TPO, Irgacure TPO-L, Irgacure OXE01, Irgacure OXE02, Irgacure 1300 or Irgacure 907. These photopolymerization initiator may be used alone or may be used as a mixture of some of the initiators at an optional ratio.

When a benzophenone compound or a thioxanthone compound is used as the photopolymerization initiator, an auxiliary agent may be additionally used to promote optical polymerization reaction. Examples of such an auxiliary agent include amine compounds such as triethanolamine, methyldiethanolamine, triisopropanolamine, n-butylamine, N-methyldiethanolamine, diethylaminoethyl methacrylate, Michler's ketone, 4,4'-diethylaminophenone, ethyl 4-dimethylaminobenzoate, (n-butoxy)ethyl 4-dimethylaminobenzoate, and isoamyl 4-dimethylaminobenzoate.

The amounts of the photopolymerization initiator and the auxiliary agent added can be in such a range that the liquid crystallinity of the composition including the nematic liquid crystal monomer used in the present invention is not affected. The amount of the photopolymerization initiator added is preferably 0.5 to 10 parts by mass inclusive, more preferably 2 to 8 parts by mass inclusive, based on 100 parts by mass of ultraviolet-curable compound in the liquid crystal composition. The amount of the auxiliary agent added to the liquid crystal composition is preferably 0.5 to 2 times larger than the mass of the photopolymerization initiator.

The composition further includes a solvent. Such a solvent is not particularly limited as long as the solvent dissolves the liquid crystal monomer and the chiral agent in use and the like. The solvent is, for example, methyl ethyl ketone, toluene, methyl isobutyl ketone, cyclopentanone, acetone and anisole, and is preferably, for example, cyclopentanone which has good solubility. These solvents may be added together at an optional ratio, and only one or a plurality of solvents may be used together. These solvents are removed by drying through an oven or a dry zone on a film coater line.

The following describes a method of producing each visible light reflection layer and the light reflection layer PRL-1 to be used in the light reflection film according to the present invention by using the above-described cholesteric liquid crystal. In such a method, for example, a required amount of a chiral agent causing right-handed or left-handed helical orientation is added to a nematic liquid crystal monomer having a polymerizable group so as to reflect light having a desired wavelength. Subsequently, these are dissolved into a solvent, and then a photopolymerization initiator is added. Thereafter, this solution is coated on a plastic substrate such as a PET film so that the thickness thereof is uniform as possible, and then the film is left to stand for a constant time under such a temperature condition that cholesteric liquid crystal is obtained on the plastic substrate and oriented at a desired helical pitch, while the solvent is removed by heating. In this case, when orientation processing such as rubbing or stretching is performed on the surface of the plastic substrate before the coating, the cholesteric liquid crystal can be more uniformly oriented, and the haze value of each light reflection layer can be reduced. Subsequently, while this orientation state is held, the film is irradiated with ultraviolet from, for example, a high-pressure mercury lamp to fix the orientation of the cholesteric liquid crystal, thereby obtaining each visible light reflection layer and the light reflection layer PRL-1 used to form the light reflection film according to the present invention. For example, when a chiral agent that causes right-handed helical orientation is selected, each light reflection layer and the light reflection layer PRL-1 thus obtained selectively reflect right-handed circularly polarized light. When a chiral agent that causes left-handed helical orientation is selected, each visible light reflection layer and the light reflection layer PRL-1 thus obtained selectively reflect left-handed circularly polarized light. This phenomenon that particular circularly polarized light is selectively reflected is referred to as selective reflection, and a selectively reflected wavelength band is referred to as a selective reflection region.

Another method of adjusting the reflectances to ordinary light of each visible light reflection layer and the light reflection layer PRL-1 used in the light reflection film according to the present invention includes, for example, changing the thicknesses of each visible light reflection layer and the light reflection layer PRL-1. The thicknesses of each visible light reflection layer and the light reflection layer PRL-1 are each, for example, 0.5 to 10 μm depending on the kinds of cholesteric liquid crystal and a chiral agent to be used, and may be identical or different as long as the reflectances to ordinary light of each visible light reflection layer and the light reflection layer PRL-1 can be adjusted to a desired range.

In case where a mirror display is produced by using the light reflection film according to the present invention thus obtained, when the light reflection film reflects circularly polarized light and an image display apparatus such as a liquid crystal display (LCD) or an organic EL display (OLED) emits circularly polarized light, the light reflection film according to the present invention may be arranged on the front surface of the image display apparatus so that the circularly polarized light is transmitted. However, an LCD or an OLED including a polarized filter generally emits linearly polarized light. Thus, a quarter wave plate is preferably used to convert such linearly polarized light into circularly polarized light in a direction to be not reflected at the light reflection film, thereby displaying a bright transmission image can be achieved as a display on the mirror display. Fig. 3 illustrates a light control film 8 according to the present invention obtained by laminating a phase difference element referred to as a quarter wave plate 7 as a polarization control layer on one side of the light reflection film 6 according to the present invention. The quarter wave plate is a phase difference element having a function to convert linearly polarized light into circularly polarized light, and can be obtained by uniaxially stretching a film made of, for example, polycarbonate or cycloolefin polymer to have a phase difference equal to a quarter wavelength or by orienting horizontally oriented polymerizable liquid crystal with a thickness to have a phase difference equal to a quarter wavelength. This quarter wave plate may be used alone, or a phase difference element called wide band quarter wave plate may be used when a shift of the phase difference is large due to wavelength dispersion. The wide band quarter wave plate is a phase difference element with reduced wavelength dependency of the phase difference, and is, for example, a phase difference element obtained by laminating a half wave plate and a quarter wave plate having same wavelength dispersion so that the angle between the slow axes thereof is 60°, or a polycarbonate phase difference element (PURE-ACE WR-S manufactured by Teijin Limited) with reduced wavelength dependency of the phase difference. When light is incident on a quarter wave plate in an oblique direction as in a head up display, a phase difference changes with the incident angle of the light in some cases, depending on a phase difference element. In such a case, in a method of more precisely adjusting the phase difference, change of the phase difference with the incident angle can be reduced, by using, for example, a phase difference element, the refractive index of which is adjusted. As an example of such adjustment, a coefficient Nz given in Formula (2) below is preferably controlled to be 0.3 to 1.0, more preferably 0.5 to 0.8 approximately, where nx represents a refractive index in the direction of the slow axis in the plane of the phase difference element, ny represents a refractive index in a direction orthogonal to nx in the plane of the phase difference element, and nz represents a refractive index in the thickness direction of the phase difference element.

$$Nz = (nx - nz)/(nx - ny) \dots (2)$$

When the slow axis or fast axis of a used phase difference film is angled at 45° relative to the longitudinal direction of a roll-shaped quarter wave plate, a light control film according to the present invention that the slow axis or fast axis is angled at 45°of relative to the longitudinal direction of the roll can be obtained by laminating the roll-shaped quarter wave plate and a roll-shaped light reflection film according to the present invention through roll-to-roll processing.

Instead of the lamination of the roll-shaped quarter wave plate and the roll-shaped light reflection film according to the present invention through roll-to-roll processing, the visible light reflection layers and the light reflection layer PRL-1 used in the present invention may be laminated directly on a quarter wave plate. When these light reflection layers are laminated directly on the quarter wave plate, a light reflection layer having a low haze value can be obtained without orientation processing such as rubbing. In such a case, a quarter wave plate produced from polymerizable liquid crystal is preferably used, in view of achieving excellent adhesion with cholesteric liquid crystal and improving reflectance for polarized light.

Hard court processing, fingerprint-proof processing, and the like may be provided as necessary on the surface of the light reflection film or light control film according to the present invention. The hard court processing is preferably provided on a side as an outermost layer when the mirror display is produced. For example, a hard courting agent may be coated on the outermost layer or a film provided with hard court processing may be laminated on the outermost layer by an adhesive agent or a pressure sensitive agent. Some hard courts are provided with fingerprint-proof processing, and suitably applicable. A light reflection film or light control film provided with such hard court processing is also an embodiment of the present invention.

A mirror display according to the present invention can be obtained by arranging the obtained light reflection film or light control film according to the present invention on the front surface of a typically used image display apparatus such as an LCD or an OLED. Fig. 4 exemplarily illustrates a mirror display 10 according to the present invention including a light reflection film or light control film 8 according to the present invention and an image display apparatus 9. When the light control film is used, the light control film is preferably arranged so that a quarter wave plate is positioned on the image display apparatus 9 side and polarized light from the image display apparatus is not reflected by each visible light reflection layer and the light reflection layer PRL-1. For example, when the image display apparatus emits linearly polarized light and the light reflecting film of the present invention that the visible light reflection layers and the light reflection layer PRL-1 are made of a cholesteric liquid crystal layer reflecting right-handed circularly polarized light is used, the quarter wave plate is preferably arranged in such a direction that linearly polarized light from the display is converted into left-handed circularly polarized light. With this configuration, the light emitted from the image display apparatus reaches a viewer with almost no reflection at these light reflection layers, and thus the viewer can observe a bright display image. An LCD always includes a polarization plate because of the operational principle thereof, and thus preferably includes the light control film according to the present invention. In a case of an OLED, a circular polarization plate is arranged on the front surface for glare prevention in some cases. In such a case, the OLED emits linearly polarized light, and thus preferably includes the light control film according to the present invention. However, when the OLED is made of a circular polarization light-emitting element, it is preferable to use the light reflection film according to the present invention. The image display apparatus may be an LCD or OLED including a flexible substrate made of plastic such as polyimide or polyethylene naphthalate or formed of an extremely thin glass plate or the like. Such a flexible image display apparatus is also applicable to a mirror display entirely having a curved surface shape.

The light reflection film and light control film according to the present invention can reduce change of reflection color and transmission color depending on the view angles, and thus are suitable for application to a mirror display including an image display apparatus such as an LCD or an OLED, and can display a reflection image similarly to that for the front direction and a bright display image, when viewed at any angles. In addition, when applied to a deformable display or a mirror display having a curved surface shape, the light reflection film and light control film according to the present invention allow a uniform reflection image or a uniform image to be displayed on the display.

[Examples]

The present invention will be exemplarily described below in detail with reference to examples. In the examples, the word "parts" means "parts by mass".

Preparation of Coating solution (liquid crystal composition)

Examples (R1), (R2), (R3), and (R4) of Coating solution having compositions listed in Table 1 were prepared.

[Table 1]

| COMPOSITION TABLE OF COATING SOLUTION (R1) | | |
|---|---|---|
| Material (kind) | Material name (manufacturer) | Amount added (parts by mass) |
| Polymerizable liquid crystal monomer | LC242 (manufactured by BASF) | 20.00 |
| Chiral agent | LC756 (manufactured by BASF) | 1.54 |
| Photopolymerization initiator | Irgacure TPO (manufactured by BASF) | 1.00 |
| Solvent | Cyclopentanone | 80.00 |

Subsequently, Coating solutions (R2), (R3), and (R4) were prepared with the same materials and amounts except that the amount of the chiral agent added to Coating solution(R1) was changed to amounts listed in Table 2.

[Table 2]

| CHIRAL AGENT ADDED AMOUNTS OF COATING SOLUTIONS (R2) TO (R4) | |
|---|---|
| Coating solution | Chiral agent added amount (parts by mass) |
| Coating solution (R2) | 1.29 |
| Coating solution (R3) | 1.11 |
| Coating solution (R4) | 0.91 |

[Example 1]

<Production of light reflection film>

The visible light reflection layer PRL-2, the visible light reflection layer PRL-3, the visible light reflection layer PRL-4, and the visible light reflection layer PRL-1 were produced in the following procedure by using prepared Coating solutions (R1), (R2), (R3) and (R4), respectively, and subsequently they were laminated to produce the light reflection film according to the present invention. A used plastic substrate was a PET film (having the product name "A4100" and a thickness of 50 $\mu$m) manufactured by Toyobo Co., Ltd. which has been subjected to rubbing process on no-undercoat surface in advance by a method disclosed in Example 1 of Japanese Patent Application Laid-Open No. 2002-90743.

(1) Each of the Coating solutions was coated on the rubbed surface of the respective PET films at room temperature by using a wire bar so that each visible light reflection layer has a thickness of 4 $\mu$m and the light reflection layer PRL-1 has a thickness of 4.5 $\mu$m after drying.

(2) Each of coated film was heated at 150°C for 5 minutes to remove a solvent, thereby obtaining a cholesteric liquid crystal phase. Then, the cholesteric liquid crystal phase was subjected to UV irradiation at power of 120 W for 5 to 10 seconds by a high-pressure mercury lamp (manufactured by HARISON TOSHIBA LIGHTING Corporation) to fix the cholesteric liquid crystal phase, thereby producing a single visible light reflection layer or light reflection layer PRL-4 on each PET film.

(3) Visible light reflection layer sides of the visible light reflection layer PRL-2 (obtained by using Coating solution (R1)) on the PET film and the visible light reflection layer PRL-3 (obtained by using Coating solution (R2)) on the PET film, which were produced in (1) and (2) were laminated by using an acrylic pressure sensitive adhesive (acrylic pressure sensitive adhesive SK-Dyne 906 manufactured by Soken Chemical & Engineering CO., Ltd.). Similarly, light reflection layer sides of the visible light reflection layer PRL-4 (obtained by using Coating solution (R3)) and the light reflection layer PRL-1 (obtained by using Coating solution (R4)) were laminated by using the acrylic pressure sensitive adhesive.

(4) The PET films on the visible light reflection layer PRL-3 side and the visible light reflection layer PRL-4 side were peeled off.

(5) Similarly to (3), the visible light reflection layer PRL-3 side and the visible light reflection layer PRL-4 side were laminated by using an acrylic pressure sensitive adhesive same as that in (3).

(6) Lastly, the PET films on the outsides of the laminated visible light reflection layer PRL-2 and light reflection layer PRL-1 were peeled off, thereby obtaining the light reflection film according to the present invention.

In this manner, the light reflection film according to the present invention was obtained that includes the four layers of the visible light reflection layer PRL-2, the visible light reflection layer PRL-3, the visible light reflection layer PRL-4 and the light reflection layer PRL-1 laminated in the stated order, and in which the sum of the thicknesses of each light reflection layer and the adhesive layer is 50 $\mu$m. The central reflected wavelengths of the visible light reflection layer PRL-2, the visible light reflection layer PRL-3, the visible light reflection layer PRL-4 and the light reflection layer PRL-1 were 450 nm, 530 nm, 610 nm and 720 nm, respectively, as listed in Table 3 below. The reflectances of the visible light reflection layer PRL-2, the visible light reflection layer PRL-3, the visible light reflection layer PRL-4, and the light reflection layer PRL-1 at the respective central reflected wavelengths were 50%, 50%, 50% and 48%, respectively.

[Table 3]

| TABLE 3: REFLECTION CHARACTERISTICS OF LIGHT REFLECTION LAYERS USED IN EXAMPLE 1 | | | | |
|---|---|---|---|---|
| Light reflection layer | 80% reflectance relative to maximum reflectance (short wavelength side) (%) | 80% reflectance relative to maximum reflectance (long wavelength side) (%) | Central reflected wavelength (nm) | Reflectance at central reflected wavelength (%) |
| PRL-1 | 678 | 762 | 720 | 48 |
| PRL-2 | 425 | 475 | 450 | 50 |
| PRL-3 | 500 | 560 | 530 | 50 |
| PRL-4 | 575 | 645 | 610 | 50 |

Reflection color and transmission color were achromatic color when the obtained light reflection film according to the present invention was observed in the front direction. Subsequently, when the film was observed at an angle of 50° approximately with respect to the front direction, reflection color and transmission color were achromatic color with substantially no change from those for the front direction. The hue of transmission color in the front direction was measured to be a* (0°) = 0.96 and b* (0°) = -0.1 by using a spectrophotometer (manufactured by Shimadzu Corporation and having the product name "MPC-3100"). On the other hand, the hue of transmission color at 50° was measured to be a* (50°) = 3.4 and b* (50°) = 10.1.

<Production of light control film>

Subsequently, a high-band quarter wave plate (manufactured by Teijin Limited; PURE-ACE WR-S) was laminated on the light reflection layer PRL-1 included in the produced light reflection film according to the present invention by using the above-described acrylic pressure sensitive adhesive, thereby obtaining the light control film according to the present invention. The light control film had a thickness of 150 $\mu$m.

<Production of mirror display>

The produced light control film according to the present invention was laminated on the front surface of a laptop personal computer (manufactured by Panasonic Corporation; Let's note SX2) as LCD by using the above-described acrylic pressure sensitive adhesive so that the quarter wave plate is arranged on the LCD side and the polarization axis of a polarization plate on the front surface of the LCD is angled at 45° relative to the slow axis of the quarter wave plate, thereby obtaining a mirror display according to the present invention. Then, the mirror display was driven to display divided parts of a screen thereof in blue, green, red, white, and black. The black display part exhibited reflection as a mirror, and no coloring was observed on a reflection image at the part when viewed in the front direction and when viewed in an oblique direction at 50°. Images at the blue, green, red, and white display parts were bright, were not colored when viewed in the front direction and when viewed in an oblique direction at 50°, and were displayed clearly.

[Comparative Example 1]

A light reflection film that includes the visible light reflection layer PRL-2, the visible light reflection layer PRL-3 and the visible light reflection layer PRL-4, and in which the sum of the thicknesses of each light reflection layer and the adhesive layer is 40 $\mu$m was produced by a production method similarly to that in Example 1 except that the light reflection layer PRL-1 was not used. As listed in Table 3, the central reflected wavelengths of the visible light reflection layer PRL-2, the visible light reflection layer PRL-3 and the visible light reflection layer PRL-4 were 450 nm, 530 nm, and 610 nm, respectively, and the reflectances of the visible light reflection layer PRL-2, the visible light reflection layer PRL-3, the visible light reflection layer PRL-4 at the respective central reflected wavelengths were 50%, 50% and 50%, respectively.

Reflection color and transmission color were achromatic color when the obtained light reflection film was observed in the front direction. Subsequently, when the film was observed at an angle of 50° approximately with respect to the front direction, reflection color was colored in blue green, and transmission color was colored in red. The hue of transmission color in the front direction was measured to be a* (0°) = 1.86 and b* (0°) = 1.39 by using a spectrophotometer (manufactured by Shimadzu Corporation and having the product name "MPC-3100"). However, the hue of transmission color at 50° was measured to be a* (50°) = 17.1 and b* (50°) = 30.8, which indicates significant hue change.

Subsequently, through an operation similarly to that in Example 1, a quarter wave plate was laminated on the visible light reflection layer PRL-4, thereby obtaining a light control film. The light control film had a thickness of 140 μm. The produced light control film was laminated on the front surface of a laptop personal computer (manufactured by Panasonic Corporation: Let's note SX2) same as that in Example 1 by using the above-described acrylic pressure sensitive adhesive so that the quarter wave plate is arranged on the LCD side and the polarization axis of a polarization plate on the front surface of the LCD is angled at 45° relative to the slow axis of the quarter wave plate, thereby producing a mirror display. Then, the mirror display was driven to display divided parts of a screen in blue, green, red, white, and black. The black display part exhibited reflection as a mirror, and a reflection image at the part was not colored when viewed in the front direction, but was colored in blue green when viewed in an oblique direction at 50°. Images at the blue, green, red, and white display parts were bright and not colored when viewed in the front direction. However, when viewed in an oblique direction at 50°, the images at these display parts were colored in red and not displayed clearly unlike those in the front direction.

Example 1 and Comparative Example 1 are compared, regarding Comparative Example 1, reflected light and transmitted light in an oblique direction at 50° were colored in blue green and red, respectively, due to shift of the reflected wavelength of each laminated light reflection layer toward the short wavelength side, which is caused by change in the view angle, and as a result, a reflection image similarly to that of a normal mirror could not be displayed as a mirror at the mirror display, and a clear display image could not be displayed as a display. However, in Example 1, the reflected wavelength of the light reflection layer PRL-1 shifted toward the short wavelength side in accordance with the view angle, thereby reducing coloring of reflected light and transmitted light. Accordingly, reflection and display images similar to those for the front direction were observed despite of change of the view angle, and as a result, a reflection image similarly to that of a normal mirror was displayed as a mirror at the mirror display, and a clear display image was displayed as a display.

The light reflection film or light control film according to the present invention can be used to obtain a mirror display that is capable of displaying reflection and display images similar to those for the front direction despite of change of the view angle and provides excellent visibility. Thus, for example, when the mirror display according to the present invention is used in place of a mirror in a restroom or a shop, an image of an observer can be observed at parts where no image is displayed, like a normal mirror, and various kinds of information can be displayed at parts where images are desired to be displayed. Accordingly, it is possible to acquire information from the display while watching a mirror. Moreover, such a mirror display can display reflection and display images similarly to those for the front direction when viewed not in the front direction, and thus is applicable to various space designs and the like for which a wide view angle is required.

List of Reference Signs

1    visible light reflection unit
2    visible light reflection layer (PRL-2)
3    visible light reflection layer (PRL-3)
4    visible light reflection layer (PRL-4)
5    light reflection layer PRL-1
6    light reflection film
7    quarter wave plate
8    light reflection film or light control film
9    image display apparatus
10   mirror display

**Claims**

1. A light reflection film **characterized by** comprising:

   a visible light reflection unit including at least one visible light reflection layer having a reflection band in which a visible light average reflectance is higher than 25% and equal to or lower than 55% in part or all of a visible light range equal to or longer than 400 nm and shorter than 700 nm; and
   a light reflection layer PRL-1 having a central reflected wavelength of 700 nm to 950 nm inclusive and having a reflectance higher than 25% and equal to or lower than 55% to ordinary light at the central reflected wavelength,

   wherein the visible light reflection layer and the light reflection layer PRL-1 both reflect polarized light in an identical direction.

2. The light reflection film according to claim 1, **characterized in that** the visible light reflection unit includes at least one visible light reflection layer among:

   a visible light reflection layer PRL-2 having a central reflected wavelength equal to or longer than 400 nm and shorter than 500 nm and having a reflectance higher than 25% and equal to or lower than 55% to ordinary light at the central reflected wavelength;
   a visible light reflection layer PRL-3 having a central reflected wavelength equal to or longer than 500 nm and shorter than 600 nm and having a reflectance higher than 25% and equal to or lower than 55% to ordinary light at the central reflected wavelength; and
   a visible light reflection layer PRL-4 having a central reflected wavelength equal to or longer than 600 nm and shorter than 700 nm and having a reflectance higher than 25% and equal to or lower than 55% to ordinary light at the central reflected wavelength.

3. The light reflection film according to claim 2, **characterized in that** the visible light reflection unit includes three visible light reflection layers of the visible light reflection layer PRL-2, the visible light reflection layer PRL-3 and the visible light reflection layer PRL-4.

4. The light reflection film according to any one of claims 1 to 3, **characterized in that** the visible light reflection layer and the light reflection layer PRL-1 are each a cholesteric liquid crystal layer having a fixed helical orientation.

5. A light control film **characterized in that** the light reflection film according to any one of claims 1 to 4 and a quarter wave plate are laminated.

6. A mirror display **characterized in that** the light reflection film according to any one of claims 1 to 4 or the light control film according to claim 5 is arranged on a front surface of an image display apparatus.

7. The mirror display according to claim 6, **characterized in that** the image display apparatus is a liquid crystal display or an organic EL display.

8. The mirror display according to claim 7, **characterized in that** the image display apparatus is a liquid crystal display or an organic EL display including a flexible substrate.

9. The mirror display according to claim 8, **characterized in that** the display entirely has a curved surface shape.

FIG. 1

FIG. 2

FIG. 3

FIG. 4

## INTERNATIONAL SEARCH REPORT

| International application No. |
| --- |
| PCT/JP2017/011349 |

### A. CLASSIFICATION OF SUBJECT MATTER

*G02B5/30*(2006.01)i, *G02B5/08*(2006.01)i, *G02B5/26*(2006.01)i, *G02F1/1333* (2006.01)i, *G02F1/1335*(2006.01)i

According to International Patent Classification (IPC) or to both national classification and IPC

### B. FIELDS SEARCHED

Minimum documentation searched (classification system followed by classification symbols)
G02B5/30, G02B5/00-5/136, G02B5/26, G02F1/1333, G02F1/1335, G09F9/30, H01L27/32

Documentation searched other than minimum documentation to the extent that such documents are included in the fields searched
Jitsuyo Shinan Koho  1922-1996 Jitsuyo Shinan Toroku Koho 1996-2017
Kokai Jitsuyo Shinan Koho 1971-2017 Toroku Jitsuyo Shinan Koho 1994-2017

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
| --- | --- | --- |
| X<br>Y | JP 2007-65314 A (Nippon Zeon Co., Ltd.),<br>15 March 2007 (15.03.2007),<br>paragraphs [0001], [0013] to [0016], [0019],<br>[0021] to [0025], [0028], [0062] to [0065],<br>[0069] to [0070], [0081] to [0086]; fig. 1<br>(Family: none) | 1-5<br>6-9 |
| Y | WO 2016/006507 A1 (Sharp Corp.),<br>14 January 2016 (14.01.2016),<br>paragraphs [0002], [0017] to [0019], [0084];<br>fig. 1<br>& CN 106471399 A  & TW 201608288 A | 6-9 |
| A | JP 2005-91825 A (Nippon Zeon Co., Ltd.),<br>07 April 2005 (07.04.2005),<br>entire text; fig. 1 to 7<br>(Family: none) | 1-9 |

☒ Further documents are listed in the continuation of Box C. ☐ See patent family annex.

| | |
| --- | --- |
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br> 31 May 2017 (31.05.17) | Date of mailing of the international search report<br> 13 June 2017 (13.06.17) |
| --- | --- |
| Name and mailing address of the ISA/<br> Japan Patent Office<br> 3-4-3,Kasumigaseki,Chiyoda-ku,<br> Tokyo 100-8915,Japan | Authorized officer<br><br>Telephone No. |

Form PCT/ISA/210 (second sheet) (January 2015)

**INTERNATIONAL SEARCH REPORT**

International application No.

PCT/JP2017/011349

C (Continuation).   DOCUMENTS CONSIDERED TO BE RELEVANT

| Category* | Citation of document, with indication, where appropriate, of the relevant passages | Relevant to claim No. |
|---|---|---|
| A | WO 2016/035624 A1  (Sharp Corp.),<br>10 March 2016 (10.03.2016),<br>entire text; fig. 1 to 8<br>(Family: none) | 1-9 |
| A | JP 2004-361774 A  (Sumitomo Chemical Co., Ltd.),<br>24 December 2004 (24.12.2004),<br>entire text; fig. 1 to 8<br>(Family: none) | 1-9 |
| A | JP 2006-184731 A  (Kyodo Printing Co., Ltd.),<br>13 July 2006 (13.07.2006),<br>entire text; fig. 1 to 10<br>(Family: none) | 1-9 |

Form PCT/ISA/210 (continuation of second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005521086 A
- JP 2007511792 A
- JP 2003315556 A
- JP 2004029824 A
- JP 2002179668 A
- JP 2002090743 A